(19) Europäisches Patentamt
European Patent Office
Office européen des brevets

(11) **EP 1 780 553 A1**

(12) **EUROPEAN PATENT APPLICATION**
published in accordance with Art. 158(3) EPC

(43) Date of publication:
**02.05.2007 Bulletin 2007/18**

(51) Int Cl.:
***G01R 31/36*** *(2006.01)*

(21) Application number: **05768869.9**

(22) Date of filing: **08.08.2005**

(86) International application number:
**PCT/JP2005/014537**

(87) International publication number:
**WO 2006/019005 (23.02.2006 Gazette 2006/08)**

(84) Designated Contracting States:
**DE FR GB IT**

(30) Priority: **17.08.2004 JP 2004237026**

(71) Applicant: **YAZAKI CORPORATION
Minato-ku
Tokyo 108-8333 (JP)**

(72) Inventor: **ARAI, Youichi
Shizuoka
4101194 (JP)**

(74) Representative: **Viering, Jentschura & Partner
Steinsdorfstrasse 6
80538 München (DE)**

(54) **DISCHARGEABLE CAPACITANCE DETERMINING METHOD**

(57)    Voltage V2 is calculated by subtracting a terminal voltage at an end of discharge F. V. and a voltage drop (Rn + Rpolsat) * Ip caused by a maximum internal resistance (Rn + Rpolsat) of a battery at a given time. A quotient is calculated by dividing V2 by terminal voltage drop V1 after all charged capacity SOC2 (Ah) of a given battery is fully discharged. A dischargeable capacity (Ah) is calculated by multiplying the quotient by a given charged capacity SOC2 (Ah).

FIG. I

EP 1 780 553 A1

**Description**

[technical field]

This invention relates to a dischargeable capacity detecting method, in particular, for detecting a dischargeable capacity of a battery.

[back ground]

For example, a battery mounted on a vehicle of an electric powered car having a motor as a single driving source corresponds to gasoline of a vehicle having a conventional engine as a driving source. Therefore, it is very important to know how the battery is charged for securing a safety driving.

Therefore, conventionally, for knowing how the battery is charged, a charging condition (%) as a relative value, and a charging capacitor (Ah) as an absolute value are detected from an open circuit voltage of an equilibrium state battery (for example, Patent Document 1).

$$\text{charging condition (\%)} = \{\ (OCVn - OCVe)\ /\ (OCVf - OCVe)\ \} * 100$$

$$\text{charging capacitor (Ah)} = \text{charging condition (\%)} * SOCf\ (Ah)$$

Where, OCVn is an open circuit voltage of an equilibrium state battery at a given state, and OCVf is an open circuit voltage of an equilibrium battery at a full charge condition. Further, OCVe is an open circuit voltage of an equilibrium battery at fully discharged condition, and SOCf is a fully charged capacitor (Ah).
[Patent Document 1] Japanese Published Patent Application No. 2002-303658

[disclosure of the invention]

[problem to be solved by the invention]

The SOC corresponds to a charge amount (coulomb amount) charged in a battery. However, all of the charge amount cannot be used. The reason is, when a discharge current flows, a voltage drop is generated owing to an internal resistance of the battery. An amount of the voltage drop is varied owing to the SOC, an amount of the discharge current, discharge time, temperature. As the voltage drop increases, the charge amount to be able to discharge decreases.

Conventionally, the voltage drop is not taken into account of the SOC. Therefore, a correct charge amount to be discharged to the load is not grasped. Namely, only monitoring the SOC cannot correctly grasp a state of the battery.

Accordingly, an object of the present invention is to provide a dischargeable capacity detecting method to grasp correctly a state of a battery.

[means for solving problem]

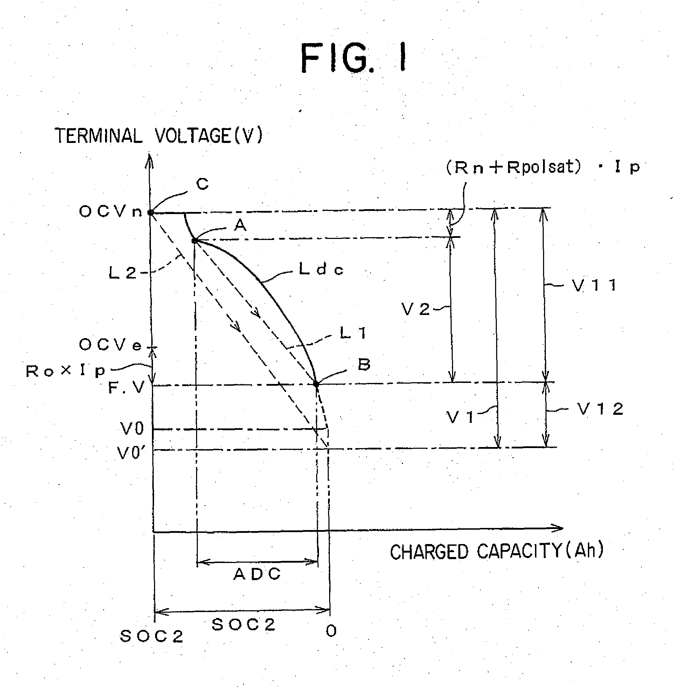

According to the claim 1, as shown in Fig. 1, there is provided a dischargeable capacity detecting method for detecting a dischargeable capacity ADC (Ah) to be dischargeable to a load from a given charged capacity SOC2 (Ah) charged in a battery at a given state comprising the steps of:

in a discharge curve Ldc showing a variation of the charged capacity corresponding to a variation of a terminal voltage when the equilibrium state battery at a given state is discharged with a predetermined current Ip,
drawing a first straight line L1 connecting a point A on the terminal voltage which is attained by subtracting an inner resistance voltage drop {(Rn + Rpolstat) * Ip} generated by a maximum internal resistance of the battery at the given state (Rn + Rpolsat) when discharging with the predetermined current Ip from an open circuit voltage of the given equilibrium state battery OCVn, and a point B on a terminal voltage F. V. at an end of discharge when discharging with the predetermined current Ip,
drawing a second straight line L2 being parallel to the first straight line L1, and passing a point C on the given charged capacity SOC2 (Ah) in the discharge curve Ldc,
estimating a terminal voltage drop V1 as a terminal drop from the given charged capacity SOC2 (Ah) to a point where a charged capacity is zero,

dividing a voltage V2, which is calculated by subtracting the terminal voltage F. V. at the end of discharge and the internal resistance voltage drop {(Rn + Rpolsat) * Ip} from the open circuit voltage of the equilibrium state battery at the given state OCVn, by an estimated terminal voltage drop V1,

multiplying the quotient by the given charged capacity SOC2 (Ah), and

regarding the product as the dischargeable capacity ADC (Ah).

According to the invention claimed in claim 1, the dischargeable capacity (Ah) is calculated by multiplying the given charged capacity SOC2 (Ah) by a quotient calculated by dividing the voltage V2 by the estimated terminal voltage drop V1, said V2 is calculated by subtracting the terminal voltage at the end of discharge F. V. and the voltage drop (Rn + Rpolsat) * Ip generated by the maximum internal resistance of the battery at the given state (Rn + Rpolsat) from the open circuit voltage of the equilibrium state battery at the given state OCVn.

Accordingly, a capacity (Ah) really dischargeable to the load is calculated by subtracting an undischargeable capacity from the charged capacity SOC2 (Ah) charged in the battery. Further, the dischargeable capacity ADC (Ah) is calculated by using a ratio of terminal voltage drop V1 to the voltage V2 which is the same as a ratio of the given charged capacity SOC2 (Ah) to the dischargeable capacity ADC (Ah), so that the dischargeable capacity ADC (Ah) is calculated correctly.

According to the invention as claimed in claim 2, as shown in Fig. 1, there is provided the dischargeable capacity detecting method as claimed in claim 1,

wherein a given charged state as a relative value of the open circuit voltage of the equilibrium state battery at the given state OCVn is calculated when an open circuit voltage at a fully charged equilibrium state is 100 %, and an open circuit voltage at an end of discharge and equilibrium state is 0%,

wherein the terminal voltage drop V1 is estimated based on the calculated given charged state.

According to the invention claimed in claim 2, a given charged state as a relative value of the open circuit voltage of the equilibrium state battery at the given state OCVn is calculated when an open circuit voltage at a fully charged equilibrium state is 100 %, and an open circuit voltage at an end of discharge and equilibrium state is 0%. The terminal voltage drop V1 is estimated based on the calculated given charged state. Therefore, by focusing that the terminal voltage drop V1 depends on the given charged state, the terminal voltage drop V1 is correctly estimated from the given charged state.

According to the invention as claimed in claim 3, as shown in Fig. 1, there is provided the dischargeable capacity detecting method as claimed in claim 1 or 2,

wherein the terminal voltage drop V1 is estimated based on the internal resistance voltage drop (Rn + Rpolsat) * Ip.

According to the invention as claimed in claim 3, the terminal voltage drop V1 is estimated based on the internal resistance voltage drop (Rn + Rpolsat) * Ip. Therefore, by focusing that the terminal voltage V1 depends on the internal resistance voltage drop (Rn + Rpolsat) * Ip, the terminal voltage drop V1 is correctly estimated from the internal resistance voltage drop (Rn + Rpolsat) * Ip.

According to the invention as claimed in claim 4, as shown in Fig. 1, there is provided the dischargeable capacity detecting method as claimed in claim 2 or 3, comprising the steps of:

multiplying the internal resistance voltage drop (Rn + Rpolsat) * Ip by an increasing ratio calculated from a reciprocal of the given charged state;

estimating the product as a differential V1 between the terminal voltage at the end of discharge F. V. and a zero terminal voltage V0' as a terminal voltage corresponding to the point where a charged capacity is zero on the second straight line L2,

calculating the terminal voltage drop V1 by adding a voltage V11, which is calculated by subtracting the terminal voltage at the end of discharge F. V. from the open circuit voltage of the equilibrium state battery at the given state OCVn, to the estimated differential V12.

According to the invention as claimed in claim 4, the internal resistance voltage drop (Rn + Rpolsat) * Ip is multiplied by the increasing ratio calculated by the reciprocal of the given charged state. The product is estimated as the differential V12 between the terminal voltage at the end of discharge F. V. and the zero terminal voltage V0' corresponding to the point where the charged capacity is zero on the second straight line L2. The terminal voltage drop V1 is calculated by adding the voltage V11, which is calculated by subtracting the terminal voltage at the end of discharge F. V. from the open circuit voltage of the equilibrium state battery at the given state OCVn, to the estimated differential V12. Therefore, by focusing that the terminal voltage drop V1 depends on the given charged state and the internal resistance voltage drop (Rn + Rpolsat) * Ip, the terminal voltage drop V1 is correctly calculated from the given charged state and the internal resistance voltage drop (Rn + Rpolsat) * Ip.

According to the invention as claimed in claim 5, there is provided the dischargeable capacity detecting method as claimed in claim 4,
wherein the increasing ratio α is calculated by multiplying an increasing ratio of a pure resistance Rn of the battery at the given state to a pure resistance R100 of the battery at a full charged state by the reciprocal.

According to the invention as claimed in claim 5, the increasing ratio α is calculated by multiplying the increasing ratio of the pure resistance of the battery at the given state to the pure resistance of the battery at the full charged state by the reciprocal. It is obtained by an experiment that the dischargeable capacity (Ah) calculated by using the increasing ratio α is substantially the same as a really measured dischargeable capacity (Ah).

According to the invention as claimed in claim 6, there is provided the dischargeable capacity detecting method as claimed in claim 2 or 3, comprising the steps of:

adding an increase calculated from the reciprocal of the given charged state to the internal resistance voltage drop (Rn + Rpolsat) * Ip,
estimating the sum as a differential voltage V12 between the terminal voltage at the end of discharge F. V. and the zero terminal voltage V0' corresponding to the point where the charged capacity is zero on the second straight line L2,
calculating the terminal voltage drop V1 by adding the voltage V11, which is calculated by subtracting the terminal voltage at the end of discharge F. V. from the open circuit voltage of the equilibrium state battery at the given state OCVn, to the estimated differential voltage V12.

According to the invention as claimed in claim 6, the increase calculated from the reciprocal of the given charged state is added to the internal resistance voltage drop (Rn + Rpolsat) * Ip. The sum is estimated as the differential voltage V12 between the terminal voltage at the end of discharge F. V. and the zero terminal voltage V0' corresponding to the point where the charged capacity is zero on the second straight line L2. The terminal voltage drop V1 is calculated by adding the voltage V11, which is calculated by subtracting the terminal voltage at the end of discharge F. V. from the open circuit voltage of the equilibrium state battery at the given state OCVn, to the estimated differential voltage V12. Therefore, by focusing that the terminal voltage drop V1 depends on the given charged state and the internal resistance voltage drop (Rn + Rpolsat) * Ip, the terminal voltage drop V1 is correctly estimated from the given charged state and the internal resistance voltage drop (Rn + Rpolsat) * Ip.

According to the invention as claimed in claim 7, there is provided the dischargeable capacity detecting method as claimed in claim 6,
wherein the increase is calculated by multiplying the difference between the pure resistance of the battery at the end of discharge and the pure resistance of the fully charged battery by the reciprocal.

According to the invention as claimed in claim 7, the increase is calculated by multiplying the difference between the pure resistance of the battery at the end of discharge and the pure resistance of the fully charged battery by the reciprocal. It is obtained by the experiment that the dischargeable capacity (Ah) calculated using the increase is substantially the same as the really measured dischargeable capacity (Ah).

[effect of the invention]

According to the invention claimed in claim 1, a capacity (Ah) really discharged to a load can be calculated by subtracting an undischargeable capacity owing to an internal resistance maximum value from a charged capacity charged in a battery. Further, by using a ratio of a terminal voltage drop V1 to a voltage V2 which is the same as a ratio of a charged capacity at a given state to the dischargeable capacity, the dischargeable capacity is correctly calculated, so that a dischargeable capacity detecting method which allows a state of the battery to be correctly known is attained.

According to the invention as claimed in claim 2, by focusing a terminal voltage drop depends on a given charged state, the terminal voltage drop is correctly estimated from the given charged state. Therefore, the dischargeable capacity detecting method which can correctly calculate the dischargeable capacity (Ah) is attained.

According to the invention as claimed in claim 3, by focusing that the terminal voltage drop depends on an internal resistance voltage drop, the terminal voltage drop can be correctly estimated from the internal resistance voltage drop. Therefore, the dischargeable capacity detecting method which can correctly calculate the dischargeable capacity (Ah) is attained.

According to the invention as claimed in claims 4 and 6, by focusing that the terminal voltage drop depends on the given charged state and the internal resistance voltage drop, the terminal voltage drop can be correctly estimated from the given charged state and the internal resistance voltage drop. Therefore, the dischargeable capacity detecting method which can correctly calculate the dischargeable capacity (Ah) is attained.

According to the invention as claimed in claims 5 and 7, it is obtained by an experiment that the dischargeable capacity (Ah) calculated by using an increasing ratio or an increase calculated is substantially the same as a really measured dischargeable capacity (Ah). Therefore, the dischargeable capacity detecting method which can correctly calculate the dischargeable capacity (Ah) is attained.

[brief description of drawings]

[Fig. 1] A discharge curve Ldc showing a variation of terminal voltage V with respect to a variation of a residual charged capacity (Ah) when a battery having an open circuit voltage OCVn in a equilibrium state is discharged with a peak current Ip.

[Fig. 2] A graph showing an example of a discharged current-terminal voltage characteristic expressed by a quadratic approximation equation.

[Fig. 3] A graph of discharge curves $Ldc_{80\%}$, $Ldc_{50\%}$ showing variations of terminal voltages with respect to variations of charged capacities (Ah) when the batteries of charged state (%) = 80 %, 50 % respectively are discharged to charged state (%) = 0, charged capacity (Ah) = 0 with a peak current Ip.

[Fig. 4] A graph showing a relationship between SOC1 (%) and an inner resistance of a battery.

[Fig. 5] A graph showing a relationship between an estimated ADC (Ah) and a really measured ADC (Ah).

[Fig. 6] A block diagram showing an embodiment of a battery state monitor according to the dischargeable capacity detecting method of the present invention.

[Explanations of letters or numerals]

| | |
|---|---|
| F. V. | terminal voltage at end of discharge |
| Ip | peak current (specific current) |
| OCVn | open circuit voltage of battery at given time in equilibrium state |
| OCVe | open circuit voltage at the end of discharge in the equilibrium state |
| OCVf | open circuit voltage of battery at full charge in equilibrium state |
| Rn | pure resistance at given time |
| Rpolsat | saturated polarization component of battery at given time |
| Rn + Rpolsat | maximum internal resistance of battery at given time |
| R100 | pure resistance of battery at full charge |
| R0 | pure resistance of battery at SOC2 (Ah) = 0 |
| SOC1 (%) | given charged state |
| SOC2 (Ah) | given charged capacity (Ah) |
| α | increasing rate |
| β | increasing amount |

[best mode for carrying out the invention]

The present invention will be explained with reference to figures. Fig. 1 is a graph of a discharge curve showing a variation of a terminal voltage (V) relative to a residual charged capacity (Ah) of a battery at a given condition, of which an open circuit voltage in an equilibrium state is OCVn, when a peak current Ip (= predetermined current) constantly flows from the battery. As shown in Fig. 1, as the discharge continues, the terminal voltage of the battery decreases together with the charged capacity (Ah).

In Fig. 1, OCVe is an open circuit voltage in the equilibrium state at an end of discharge. Therefore, it is necessary to use the battery so as not to make the open circuit voltage under OCVe in the equilibrium state. A resistance R0 corresponds to a pure resistance (designed value) of a new battery when the open circuit voltage in the equilibrium state becomes OCVe, namely, when in the conventional way, a charged state (%) = 0 and the charged capacity (Ah) = 0.

Further, the peak current Ip is a peak current at a high rate discharge. For example, in a battery mounted on a vehicle, when an engine starts, the discharge is done via a starter motor. At this time, so called a rush current flows. The rush current increases in a short time to a very large current relative to a normal current and decreases in a short time from the very large current to the normal current. Generally, such a discharge is called the high rate discharge.

F. V. (V) is a terminal voltage at an end of discharge, and corresponds to a value calculated by subtracting a voltage drop R0 * Ip when the peak current Ip flows via the resistance R0 from the open circuit voltage at the end of discharge OCVe. Namely, if the terminal voltage of the battery is not under the F. V. when discharge, even when a polarization is never generated (in real, the polarization is inevitably generated when discharge), the open circuit voltage after the discharge in the equilibrium state is never under the OCVe. Therefore, the battery is used so as not to make the terminal voltage during discharge under the F. V.

SOC2 (Ah) is a charged capacity (Ah) charged in a battery at a given state of which open circuit voltage in the equilibrium state is OCVn. In a real battery, there is an undischargeable capacity owing to the internal resistance or the polarization, so that all of the SOC2 (Ah) cannot discharge. However, when discharging with infinitely small current, the generation of the polarization is so small to neglect, so that the voltage drop caused by the internal resistance unlimitedly approaches to zero, and all of the SOC2 (Ah) can discharge.

Because of the reason described above, all of the SOC2 (Ah) cannot discharge when constantly discharging with the peak current Ip. However, V0 (V) corresponds to a terminal voltage when the charged capacity (Ah) = 0 supposing that after constantly discharging with the peak current Ip. Further, (Rn + Rpolsat) is a maximum internal resistance generated when the battery having the open circuit voltage OCVn discharges with the peak current Ip, and a detailed content is described later.

A dischargeable capacity (Ah: current-time product) as a capacity, which is really dischargeable to a load, of a battery having an open circuit voltage in a equilibrium state of OCVn corresponds to ADC (Ah) in Fig. 1. In detail, the capacity corresponds to a capacity (Ah) calculated by subtracting a capacity corresponding to F. V. and a capacity (Ah) corresponding to an internal resistance voltage drop (Rn + Rpolsat) * Ip in a battery during discharging (= undischargeable capacity due to the internal resistance of the battery) from SOC2 (Ah). Further, V2 corresponds to a voltage calculated by subtracting F. V. (V) and (Rn + Rpolsat) * Ip (V) from the open circuit voltage OCVn.

Now, drawing a straight line L1 (first straight line) connecting a point A and a point B on the discharge curve Ldc. Clearly from Fig. 1, the point A is on the terminal voltage calculated by subtracting (Rn + Rpolsat) * Ip from the open circuit voltage OCVn on the discharge curve Ldc. The point B is on F. V. Next, drawing a straight line L2 (second straight line) parallel to the straight line L1 and passing on a point C of the SOC2 (Ah) on the discharging curve.

In the straight line L2, regarding a terminal voltage drop from SOC2 (Ah) of the residual charged capacity (Ah) to zero on the straight line L2 as V1 (V), then a ratio of SOC2 (Ah) to ADC (Ah) corresponds to a ratio of V1 (V) to V2 (V). Therefore, when SOC2 (Ah) is acquired, and the ratio of V1 (V) to V2 (V) is estimated, ADC (Ah) can be calculated by multiplying SOC2 (Ah) by a value calculated by dividing V (2) by V (1).

SOC2 (Ah) described the above is calculated by an equation below.

$$\text{SOC2 (Ah)} = \{ (\text{OCVn} - \text{OCVe}) / (\text{OCVf} - \text{OCVe}) \} * \text{SOCf} \quad ... (1)$$

wherein OCVe is an open circuit voltage in an equilibrium state at an end of discharge (designed value), OCVf is an open circuit voltage in an equilibrium state at full charge (designed value), and SOCf(Ah) is a fully charged capacity (designed value).

Further, V2 (V) can be calculated by subtracting (Rn + R polsat) * Ip and F. V. from OCVn. OCVn is acquired by really measuring a terminal voltage of the battery when an affection of polarization generated in the battery caused by previous charge and discharge is cancelled, and the battery is in the equilibrium state having no decrease or increase caused by the polarization. Alternatively, the OCVn is acquired by estimating owing to a result of observing for a short time a variation of the terminal voltage of the battery just after charge or discharge.

The internal resistance voltage drop (Rn + Rpolsat) * Ip is calculated by the following manner. The voltage drop generated in the battery during charging is divided into the voltage drop owing to the battery's pure resistance and the internal resistance voltage drop except the voltage drop owing to the battery's pure resistance, namely, the voltage drop owing to polarization.

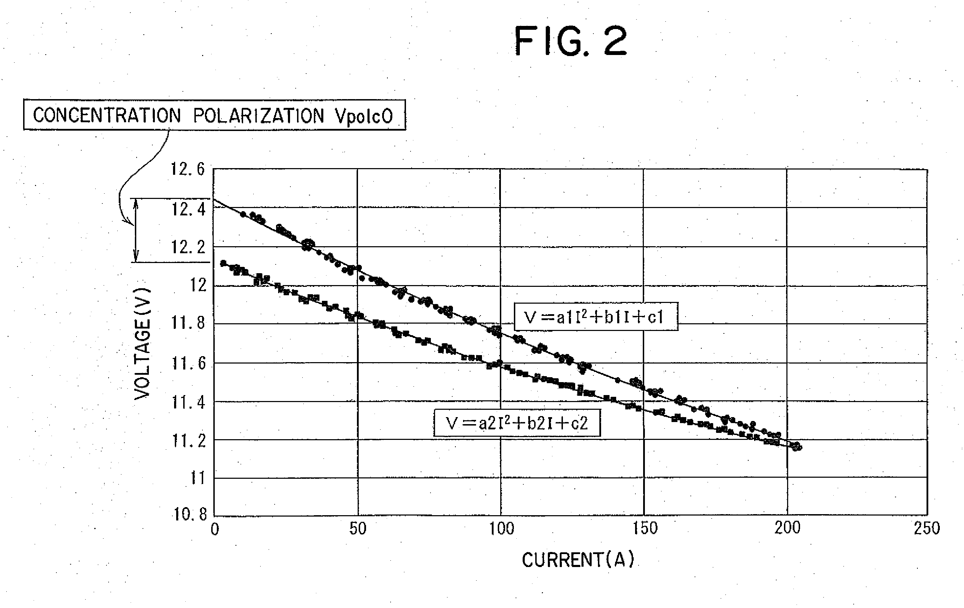

First, an example of calculating the pure resistance Rn of the battery having the open circuit voltage OCVn will be explained. A first step is discharging high rate discharge in the battery, then measuring a pair of discharge current and the terminal voltage of the battery at this time in a short fixed period. The next step is plotting the data pair on a graph of which horizontal axis is discharge current, and vertical axis is terminal voltage as shown in Fig. 2. Current-voltage characteristics at increase and decrease of discharge current shown in Fig. 2 are approximated to following quadratic equations using a least squares method.

$$V = a1 * I^2 + b1 * I + c1 \ ... (2)$$

$$V = a2 * I^2 + b2 * I + c2 \ ... (3)$$

Incidentally, in Fig. 2, the quadratic equations and curves are written.

In Fig. 2, a voltage difference (c1 - c2) between intercepts of the approximated curves of the current increase and the current decrease is a voltage difference when the current is zero (A), so that it seems to be a voltage drop owing to a concentration polarization component generated by discharge. Therefore, the concentration polarization at the current zero (A) is expressed by $Vpolc0 = (c1 - c2)$. Further, a given concentration polarization seems to be proportional to a product calculated by multiplying a current value by current flowing time, namely Ah (because of a short time, hereunder referred to as Asec).

Next, a method for calculating the concentration polarization at a current peak using the concentration polarization at the current zero Vpolc0 will be explained. Now, the concentration polarization at the current peak Vpolcp is expressed below.

$$Vpolcp = \{ (\text{Asec at the current increase}) / (\text{Asec at all the discharge}) \} *$$

$$Vpolc0 \ldots (4)$$

Incidentally, Asec at all the discharge is expressed below.

Asec at all the discharge = (Asec at the current increase + Asec at the current decrease)

One step is adding the calculated concentration polarization at the peak current Vpolcp to the Voltage at the current increase peak (equation (2)), namely, deleting the concentration polarization component at the current peak. Incidentally, a voltage after deleting the concentration polarization component at the peak current Vp1 is expressed below.

$$Vp1 = a1 * Ip^2 + b1 * Ip + c1 + Vpolcp$$

Next step is defining a voltage drop curve owing only to the pure resistance and an activation polarization with regard to the approximated curve of the current increase. An approximation equation of the voltage drop curve is expressed below.

$$V = a3 * I^2 + b3 * I + c3 \ldots (5)$$

Because in the point at the current zero before discharge, both the activation polarization and the concentration polarization are based on c1, accordingly $c3 = c1$ from the equation (2).

Further, if the current increases from an initial condition of the current increase, but a response of the concentration polarization is slow, and the response hardly proceeds, a differential value at the current zero of the equation (2) is equal to that of the equation (5), thus $b3 = b1$. Accordingly, by assigning $c3 = c1$, $b3 = b1$, the equation (5) is re-expressed by

$$V = a3 * I2 + b1 * I + c1 \ldots (6)$$

Unknown is only a3.

Next step is assigning the coordinates of the peak value of the current increase (Ip, Vp1) to the equation (6), and expanding the equation with respect to a3. Then, the following equation is obtained.

$$a3 = (V1 - b1 * Ip - c1) / Ip^2$$

Therefore, the equation (5) owing only to the pure resistance and the activation polarization is determined by the equation (6).

Next, how to delete the concentration polarization component from the current decrease curve will be explained. From a relational expression of a voltage drop curve in a direction of current decrease owing to the pure resistance and the activation polarization, the concentration polarization component can be deleted in a way equivalent to deleting the concentration polarization component at the peak current. Two points except the peak are defined as A and B, then the concentration polarizations at respective points are calculated below.

$$VpolcA = \{ \text{(Asec from the current increase to A) / (Asec of total}$$

$$\text{discharge)} \} * Vpolc0 \ldots (7)$$

$$VpolcB = \{ \text{(Asec from the current increase to B) / (Asec of total}$$

$$\text{discharge)} \} * Vpolc0 \ldots (8)$$

After calculating two points where the concentration polarization is deleted except the peak owing to the equations (7), (8), the curve of voltage drop in the current decrease direction owing to the pure resistance and the activation polarization, which is expressed below, is calculated using these two points and the peak value.

$$V = a4 * I^2 + b4 * I + c4 \ldots (9)$$

Incidentally, coefficients a4, b4, c4 of the equation (9) are determined by resolving simultaneous equations of the three points by substituting respectively the current and voltage values of the two points A, B and the peak points into the equation (9).

Next, how to calculating the pure resistance Rn will be explained. A difference between the voltage drop curve in the current increase direction owing to the pure resistance and the activation polarization deleting the concentration polarization component as shown in the equation (6) and the voltage drop curve in the current decrease direction owing to the pure resistance and the activation polarization deleting the concentration polarization component as shown in the equation (9) is a difference of the activation polarization component.

Incidentally, a differential value R1 of the current increase at the peak value and a differential value R2 of the current decrease are calculated by following equations.

$$R1 = 2 * a3 * Ip + b3 \ldots (10)$$

$$R2 = 2 * a4 * Ip + b4 \ldots (11)$$

The difference between the differential values R1 and R2 calculated by the above equations is caused by that one is a peak value of the activation polarization component in a increase direction, and the other is a peak value in a decrease direction. Further, a size of the activation polarization in principle corresponds to the discharge current. However, it is affected by the concentration polarization at any given time. When the concentration polarization is small, the activation polarization becomes small, and when the concentration polarization is large, the activation polarization becomes large. Therefore, we assume that a current voltage characteristic owing to the pure resistance is exist between rates of both near the peak value, then the pure resistance can be calculated by multiplying both of differential values respectively by ratios of monotonic increase period and monotonic decrease period to the total period of flowing a rush current and then by adding the both.

For example, if the current increase time is 3 msec, and the current decrease time is 100 msec, the pure resistance Rn is calculated as below.

$$Rn = R1 * 3 / 103 + R2 * 100 / 103 \ldots (12)$$

This pure resistance Rn is calculated and updated every time when the high rate discharge is occurred, for example, when the starter motor is driven.

The voltage drop owing to the pure resistance Rn does not change if the condition of the battery is the same. Incidentally, according to "a cell as a function of operating current" in "HANDBOOK OF BATTERIES" written by David Linden, Page 10, Fig 2.1, when a substantially large discharge current flows, a saturated polarization voltage drop which is saturated in a specific value corresponding to the amount of the current exists. Therefore, by monitoring a saturation point, a point of the voltage drop owing to the internal resistance can be monitored.

Next, how to calculate a saturated polarization $V_R pol$ (= Rpolsat * Ip) will be explained. A first step is discharging the battery. At this time, from the discharge current and the terminal voltage of the battery measured at intervals, an approximation of the terminal voltage V against a discharge current I shown in an equation (13) is calculated.

$$V = a * I^2 + b * I + c \dots (13)$$

This terminal voltage V of the battery can be also expressed as follows by a sum of a voltage drop owing to the pure resistance of the battery and a voltage drop $V_R$ owing to the internal resistance except the pure resistance (voltage drop owing to the polarization).

$$V = c \cdot (Rn * I + V_R) \dots (14)$$

From the equations (13) (14), a relational expression of the approximation, the voltage drop owing to the pure resistance, and the voltage drop owing to the polarization can be calculated.

$$a * I2 + b * I = \cdot (Rn * I + V_R) \dots (15)$$

By differentiating the equation (15), a rate of the voltage drop owing to the internal resistance except the pure resistance of the battery $dV_R / dI$ is calculated.

$$dV_R / dI = -2 * a * I \cdot b - Rn \dots (16)$$

A discharge current when the rate $dV_R / dI = 0$ corresponds to a terminal voltage drop saturated current Ipol (= - (Rn + b) / 2a) when the voltage drop owing to the internal resistance except the pure resistance of the battery becomes the maximum (saturated value).

When it is a discharge from the equilibrium state, the calculated terminal voltage drop saturated current Ipol with the pure resistance of the battery Rn as the discharge current I of the equation (15) is substituted, and the calculated voltage drop caused by the polarization $V_R\{= - a * Ipol^2 - b * Ipol - Rn * Ipol \dots (17)\}$ is regarded as the saturated voltage $V_R pol$. Incidentally, the saturated voltage $V_R pol$ is calculated and updated every time when the battery discharges. The saturated voltage $V_R pol$ corresponds to Rpolsat * Ip. Therefore, (Rn + Rpolsat) * Ip can be calculated from the pure resistance Rn calculated by the equation (12) and the saturated polarization calculated by the equation (17). Incidentally, the calculating way of (Rn + Rpolsat) * Ip is not limited to this.

Further, as shown in Fig. 1, V1 (V) can be calculated by adding V (11) as a difference between the open circuit voltage OCVn and the terminal voltage at the end of charge F. V. (V) and V (12) as a difference between the F. V. (V) and the terminal voltage V0' at the charged capacity (Ah) = 0 on the straight line L2. V11 (V) can be calculated by subtracting the F. V. (= OCVe - R0 * Ip) by a design value from the measured or estimated OCVn.

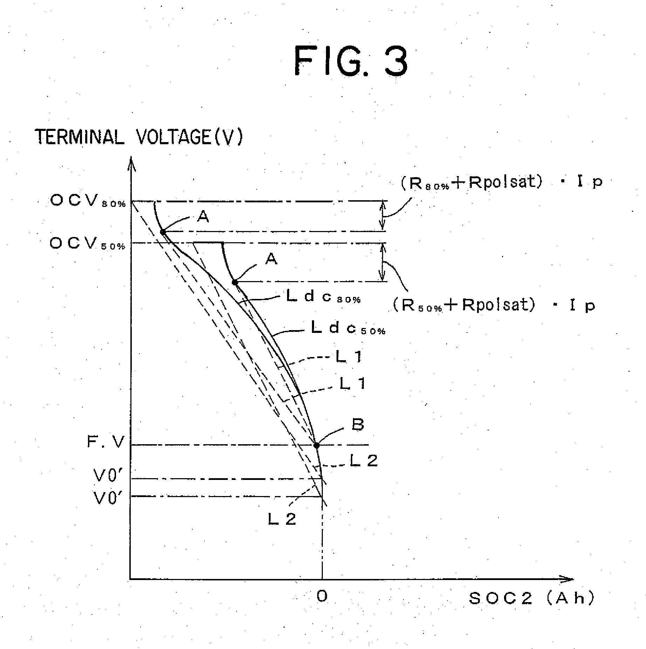

Next, how to estimate the above described V12 (V) will be explained with reference to Fig. 3. In Fig. 3, discharge curves $Ldc_{80\%}$, $Ldc_{50\%}$ respectively indicate curves of the terminal voltages corresponding to variations of charged capacity (Ah) when the batteries charged state (%) = 80 %, 50 % discharge to charged state (%) = 0, charged capacity (Ah) = 0 with the peak current Ip.

Further, $OCV_{80\%}$, $OCV_{50\%}$ are respectively open circuit voltages in the equilibrium state of the battery charged state (%) = 80 %, 50%. $(R_{80\%} + Rpolsat)$, $(R_{50\%} + Rpolsat)$ are respectively maximum internal resistances of the battery charged state (%) = 80 %, 50 %. It is also clear from the straight lines L1, L2 respectively drown on the discharge curves $Ldc_{80\%}$, $Ldc_{50\%}$, that as the charged state (%) decreases, V0' decreases and thus V12 (V) increases.

Incidentally, as the charged state (%) of the battery decreases due to discharge, the maximum internal resistance generated in the battery increases. Therefore, we consider that the ratio of V12 with respect to the voltage drop (Rn + Rpolsat) * Ip is equivalent to the internal resistance increase ratio $\alpha$ with respect to the internal resistance (Rn + Rpolsat) at the charged state (%) = 0, charged capacity (Ah) = 0. So, we assume that V12 corresponds to a product calculated by the voltage drop (Rn + Rpolsat) * Ip by the increase ratio $\alpha$.

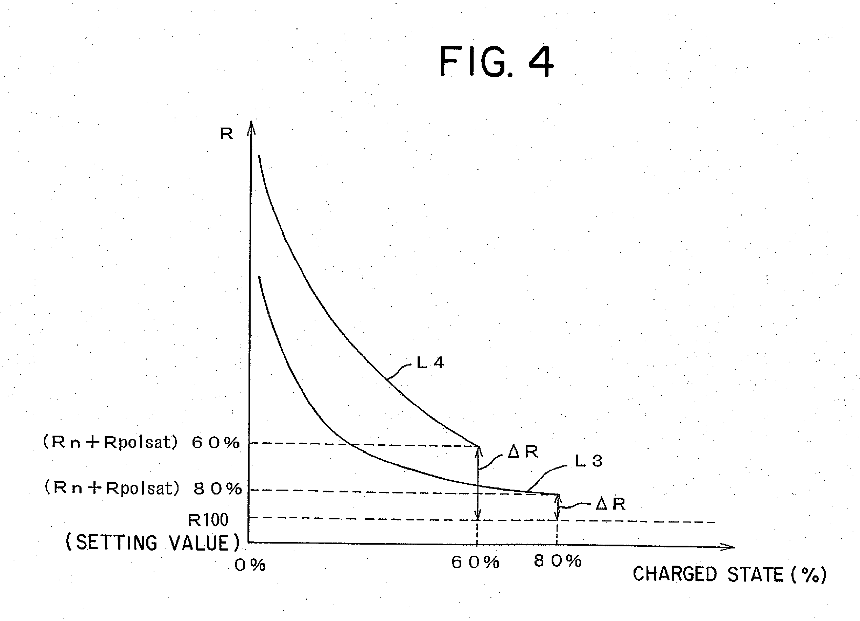

Next, how to calculate the increase ratio $\alpha$ will be explained with reference to Fig. 4. In Fig. 4, a curve L3 indicates a relationship between the charged state (%) when the battery at the charged state (%) = 80 % discharges with the peak current Ip and the internal resistance R (= pure resistance + saturated polarization resistance). Further, a curve L4 indicates a relationship between the charged state (%) when the battery at the charged state (%) = 60 % discharges to the charged state (%) = 0 with the peak current Ip and the internal resistance R (= pure resistance + saturated polarization resistance). In Fig. 4, (Rn + Rpolsat) 80 % is an internal resistance of the battery at charged state (%) = 80 %, and (Rn + Rpolsat) 60 % is an internal resistance of the battery at charged state (%) = 60 %.

As it is clear from the Fig. 4, curvatures of the curves L3, L4 correspond to 1 / SOC1 (%) (= charged state (%) before discharge, namely, charged state (%) at given time). Further, offsets $\Delta R$ of the curves L3, L4 correspond to Rn / R100. Incidentally, R100 corresponds to the pure resistance of the battery (design value) at the charged state (%) = 100. Therefore, it is assumed that the increase ratio $\alpha$ corresponds to a product calculated by multiplying 1 / SOC1 (%) by Rn /R100.

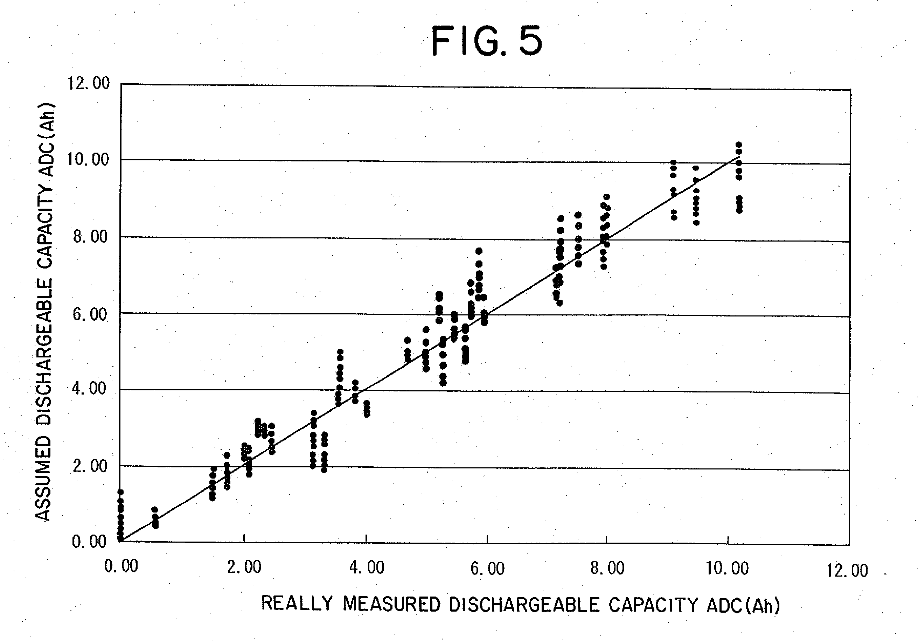

When comparing the assumed ADC (Ah) calculated by multiplying a quotient calculated by dividing V2 (V) by V1 (V) by SOC2 (Ah) with a really measured ADC (Ah), as shown in Fig. 5, both SOC2 (Ah) are substantially the same. Thus, the assumed ADC (Ah) is a correct ADC (Ah).

According to the dischargeable capacity detecting method, a really dischargeable capacity (Ah) to the load can be calculated by subtracting the undischargeable capacity owing to the maximum internal resistance (Rn + Rpolsat) from the charged capacity SOC2 (Ah) in the battery at the given time. Further, as shown in Fig. 1, a correct dischargeable capacity can be calculated by calculating the dischargeable capacity ADC (Ah) using the ratio of voltage drop V1 and V2 which is the same as the ratio ofADC (Ah) to SOC2 (Ah).

Further, according to the dischargeable capacity detecting method, a first step is calculating SOC1 (%) as a relative value of the open circuit voltage OCVn in the equilibrium state battery at the given time when the open circuit voltage at the full charge in the equilibrium state is 100 %, and the open circuit voltage at the end of discharge in the equilibrium state is 0%. Then, based on the calculated SOC1 (%) and (Rn + Rpolsat) * Ip, the voltage drop V1 is estimated. Therefore, because the voltage drop V1 depends on the SOC1 (%) and (Rn + Rpolsat) * Ip, the voltage drop V1 is correctly estimated based on the SOC1 (%) and (Rn + Rpolsat) * Ip.

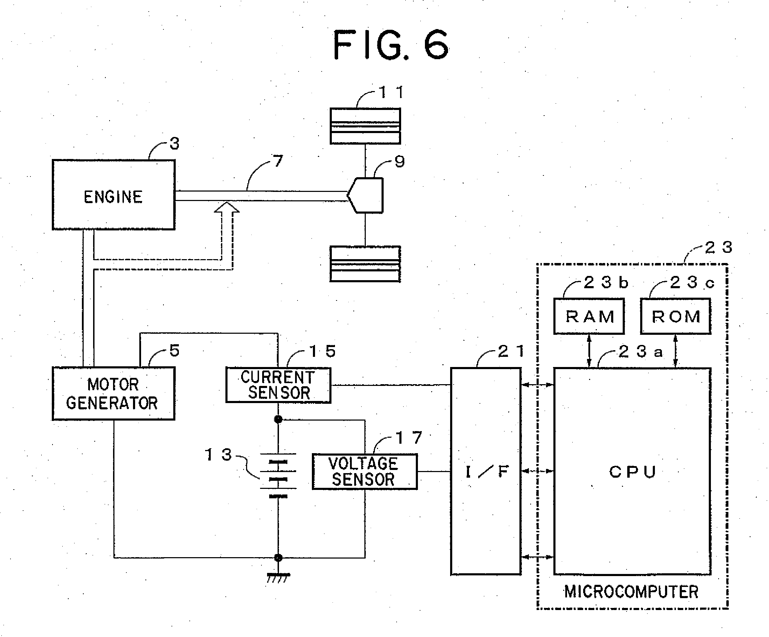

The above described dischargeable capacity detecting method according to the present invention can be performed by a structure shown in Fig. 6. Fig. 6 is a block diagram showing an embodiment of a battery state monitor performing the dischargeable capacity detecting method according to the present invention. The battery state monitor 1 in Fig. 6 is mounted on a hybrid vehicle having a motor generator 5 with an engine 3.

This hybrid vehicle normally runs by transmitting an output of the engine 3 via a driving shaft 7 and a differential case 9 to wheels 11. When a high load driving, the motor generator 5 works as a motor owing to an electric power from a battery 13. An output of the motor generator 5 and the output of the engine 3 are transmitted to the wheels 11 to perform an assist driving.

Further, in this hybrid vehicle, the motor generator 5 works as a generator when reducing speed or braking to convert a kinetic energy into electric energy so that the battery 13 mounted on the hybrid vehicle is charged to supply electricity to various loads.

The motor generator 5 also works as a starter motor for compulsory rotating a flywheel of the engine 3 when the engine starts with an on-state not-shown starter switch.

Further, the battery state monitor 1 includes: a current sensor 15 for detecting a discharge current I of the battery 13 to such as the motor generator 5 working as the assist motor and the starter motor, and a charge current from the motor generator 5 working as a generator; and a voltage sensor 17 connected parallel to the battery 13 having an infinite resistance for detecting a terminal voltage V of the battery 13.

Incidentally, the current sensor 15 and the voltage sensor 17 are arranged on a circuit which becomes a closed circuit by an on-state ignition switch.

The battery state monitor 1 of this embodiment includes: a microcomputer 23 which receives outputs of the current sensor 15 and the voltage sensor 17 after A / D converted at an interface circuit 21; and a not-shown nonvolatile memory (NVM).

The microcomputer 23 includes a CPU 23a, a RAM 23b, a ROM 23c. The interface circuit 21 is connected to the CPU 23a with the RAM 23b and the ROM 23c. Further, a signal for indicating an on / off state of the not-shown ignition switch is inputted into the CPU 23a.

The RAM 23b includes a data area for storing data and a work area for various operations. The ROM 23c includes a control program for the CPU 23a to operate.

Therefore, the microcomputer 23 detects various signals at the discharge from the current sensor 15 and the voltage sensor 17 to detect the dischargeable capacity ADC (Ah).

Incidentally, in the above embodiment, it is considered that the ratio of V12 to (Rn + Rpolsat) * Ip is equivalent to the increase ratio $\alpha$ of the internal resistance at the charged state (%) = 0, charged capacity (Ah) = 0 with respect to the internal resistance (Rn + Rpolsat), so that it is assumed that V12 corresponds to the product calculated by multiplying (Rn + Rpolsat) * Ip by the increase ratio $\alpha$. On the contrary, for example, it may be considered that the increasing amount of V12 with respect to the voltage drop (Rn + Rpolsat) is equivalent to an internal resistance increasing amount $\beta$ at charged state (%) = 0, charged capacity (Ah) = 0 with respect to the internal resistance (Rn + Rpolsat) so that it may be assumed that V12 is calculated by adding the voltage drop (Rn + Rpolsat) * Ip to the increasing amount $\beta$.

It is assumed that the increasing amount $\beta$ corresponds to a quotient calculated by dividing (R0 - R100) by SOC1 (%). When assuming ADC (Ah) by using V12 which is calculated by adding the calculated $\beta$ to (Rn + Rpolsat) * Ip, the assumed ADC (Ah) is also substantially the same as a really measured ADC (Ah).

**Claims**

1.  A dischargeable capacity detecting method for detecting a dischargeable capacity for a load in a given charged capacity charged in a battery at a given state comprising the steps of:

    drawing a first straight line connecting a point on the terminal voltage which is attained by subtracting an inner resistance voltage drop generated by a maximum internal resistance of the battery at the given state when discharging with the predetermined current from an open circuit voltage of the given equilibrium state battery, and a point on a terminal voltage at an end of discharge when discharging with the predetermined current in a discharge curve showing a variation of the charged capacity corresponding to a variation of a terminal voltage when the equilibrium state battery at a given state is discharged with a predetermined current,
    drawing a second straight line being parallel to the first straight line, and passing a point on the given charged capacity in the discharge curve,
    estimating a terminal voltage drop as a terminal drop from the given charged capacity to a point where a charged capacity is zero on the second straight line,
    dividing a voltage, which is calculated by subtracting the terminal voltage at the end of discharge and the internal resistance voltage drop from the open circuit voltage of the equilibrium state battery at the given state, by the estimated terminal voltage drop,
    multiplying the quotient by the given charged capacity, and
    regarding the product as the dischargeable capacity.

2.  The dischargeable capacity detecting method as claimed in claim 1,
    wherein a given charged state as a relative value of the open circuit voltage of the equilibrium state battery at the given state is calculated when an open circuit voltage at a fully charged equilibrium state is 100 %, and an open circuit voltage at an end of discharge and equilibrium state is 0%,
    wherein the terminal voltage drop is estimated based on the calculated given charged state.

3.  The dischargeable capacity detecting method as claimed in claim 1 or 2,
    wherein the terminal voltage drop is estimated based on the internal resistance voltage drop.

4.  The dischargeable capacity detecting method as claimed in claim 2 or 3, comprising the steps of:

    multiplying the internal resistance voltage drop by an increasing ratio calculated from a reciprocal of the given charged state;
    estimating the product as a differential between the terminal voltage at the end of discharge and a zero terminal voltage as a terminal voltage corresponding to the point where a charged capacity is zero on the second straight line,
    calculating the terminal voltage drop by adding a voltage, which is calculated by subtracting the terminal voltage at the end of discharge from the open circuit voltage of the equilibrium state battery at the given state, to the estimated differential.

5.  The dischargeable capacity detecting method as claimed in claim 4,
    wherein the increasing ratio is calculated by multiplying an increasing ratio of a pure resistance of the battery at the given state to a pure resistance of the battery at a full charged state by the reciprocal.

**6.** The dischargeable capacity detecting method as claimed in claim 2 or 3, comprising the steps of:

adding an increase calculated from the reciprocal of the given charged state to the internal resistance voltage drop,
estimating the sum as a differential voltage between the terminal voltage at the end of discharge and the zero terminal voltage corresponding to the point where the charged capacity is zero on the second straight line,
calculating the terminal voltage drop by adding the voltage, which is calculated by subtracting the terminal voltage at the end of discharge from the open circuit voltage of the equilibrium state battery at the given state, to the estimated differential voltage.

**7.** The dischargeable capacity detecting method as claimed in claim 6,
wherein the increase is calculated by multiplying the difference between the pure resistance of the battery at the end of discharge and the pure resistance of the fully charged battery by the reciprocal.

# FIG. 1

# FIG. 2

CONCENTRATION POLARIZATION VpolcO

$V = a1 I^2 + b1 I + c1$

$V = a2 I^2 + b2 I + c2$

VOLTAGE(V)

CURRENT(A)

EP 1 780 553 A1

# FIG. 3

TERMINAL VOLTAGE(V)

# FIG. 4

# FIG.5

# FIG.6

## INTERNATIONAL SEARCH REPORT

| International application No. |
| --- |
| PCT/JP2005/014537 |

A. CLASSIFICATION OF SUBJECT MATTER
*G01R31/36* (2006.01)

According to International Patent Classification (IPC) or to both national classification and IPC

B. FIELDS SEARCHED

Minimum documentation searched (classification system followed by classification symbols)
*G01R31/36* (2006.01)

Documentation searched other than minimum documentation to the extent that such documents are included in the fields searched

| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| A | JP 2002-303658 A (Yazaki Corp.),<br>18 October, 2002 (18.10.02),<br>Full text; all drawings<br>(Family: none) | 1-7 |

☐ Further documents are listed in the continuation of Box C.  ☐ See patent family annex.

| * Special categories of cited documents: | |
| --- | --- |
| "A" document defining the general state of the art which is not considered to be of particular relevance | "T" later document published after the international filing date or priority date and not in conflict with the application but cited to understand the principle or theory underlying the invention |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 01 November, 2005 (01.11.05) | 22 November, 2005 (22.11.05) |

| Name and mailing address of the ISA/ | Authorized officer |
| --- | --- |
| Japanese Patent Office | |
| Facsimile No. | Telephone No. |

Form PCT/ISA/210 (second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002303658 A